# EUROPEAN PATENT APPLICATION

(11) **EP 4 657 577 A1**
(43) Date of publication of application: **03.12.2025**
(21) Application number: 24178990.8
(22) Date of filing: 30.05.2024
(51) Int. Cl.: H01M 6/18, H01M 10/052, C23C 14/35, H01M 10/0562

(54) **SOLID STATE ELECTROLYTE AND SOLID STATE BATTERY**

(71) Applicant: Belenos Clean Power Holding AG, 2502 Bienne (CH)
(72) Inventor: PFENNINGER, Reto, 4612 Wangen bei Olten (CH); KRAVCHYK, Kostiantyn, 8052 Zürich (CH); OKUR, Faruk, 4051 Basel (CH); KOVALENKO, Maksym, 8050 Zürich (CH); DUBEY, Romain Jean-Christophe, 4313 Möhlin (CH); PEREGO, Daniele, 5400 Baden (CH)
(74) Representative: ICB SA

(57) **Abstract**

The present invention relates to a solid state electrolyte (SSE) comprising a dense membrane comprising LLZO having a thickness equal to or lower than 100 µm and a Sb-comprising coating layer having a thickness between 1 and 20 nm provided on a surface of the dense membrane, the dense membrane having a density equal to or higher than 90 % of the theoretical density of the membrane, wherein the surface of dense membrane onto which the coating layer is provided is substantially free of Li₂CO₃, wherein the SSE comprises a first Li-Sb alloy at the interface of the Sb-comprising coating layer and the LLZO-comprising dense membrane, wherein the thicknesses are as calculated from SEM images of the SSE. The invention further relates to a solid state battery (SSB) comprising the SSE and to methods of producing the SSE and the SSB.

## Description

### Technical field of the invention

The present invention is related to solid state electrolytes, solid state batteries comprising the solid state electrolytes, and to method of producing the solid state electrolytes and the solid state batteries.

### Background

The quest for safe, non-flammable, and temperature-tolerant energy storage systems with high energy and power densities has lead to research focus on batteries that consist solely of solid-state components. In particular, solid state batteries (SSBs) employing cubic Li₇La₃Zr₂O₁₂ (LLZO) garnet-type solid electrolytes are appealing as energy storage technology because of, amongst others, a high Li-ion conductivity of up to 1 mS.cm⁻¹ at room temperature, a low electronic conductivity of ≈10⁻⁸ S.cm⁻¹ at room temperature, a high thermal and mechanical stability and a wide electrochemical operation window of 0-6 V versus Li+/Li.

However, LLZO-based SSBs, still have several shortcomings that limit their use in commercial batteries, in particular the poor LLZO wettability by lithium metal, which leads to a relatively high Li/LLZO interface resistance and consequently to high voltage polarization upon lithium plating/stripping, and may even lead to the formation of dendrites as a result of inhomogeneous distribution of the applied current density over the entire interface.

Building a Better Li-Garnet Solid Electrolyte/Metallic Li Interface with Antimony, Dubey, Sastre et al., Adv. Energy Mater. 2021, 11, 2102086 discloses the use of a thin antimony layer as an interfacial layer, i.e. a layer between the metallic lithium of the anode and the LLZO solid state electrolyte (SSE). 1 mm LLZO pellets were coated with a 10 nm Sb coating. A low interface resistance of 4.1 Ω.cm² was reported, and analysis of the interface showed the presence of a Li-Sb alloy as an interlayer. Critical current densities of up to 0.64 mA.cm⁻² at room temperature were measured, as well as low overpotentials of 40-50 mV at a current density of 0.2 mA.cm⁻².

However, the abovementioned LLZO SSE with a thin antimony (Sb) coating has a thickness which is not suited for use in commercial battery cells. Further, from the viewpoint of commercial batteries, the reported interface resistance is still relatively high, and the critical current density still relatively low, leading to - should it be possible to prepare them - batteries which are still limited in performance when compared to, for example, liquid electrolyte comprising Li-ion secondary batteries.

Hence, there is a need for a further improvement in the performance of LLZO-based SSEs, in particular their performance upon repeated charging/discharging, their performance at elevated temperature, and their capability of supporting high currents and high speed charging, in combination with a reduced thickness and cost.

### Summary of the invention

It is an aim of the present invention to overcome one or more of the foregoing drawbacks. It is an aim of the present invention to provide a solid state electrolyte (SSE) for use in solid state batteries (SSB), i.e. having a commercially acceptable thickness, showing an improved performance when compared to existing SSEs for SSBs, in particular a low interface resistance, both at room temperature and at elevated temperatures, up to for example 75 °C. It is a further aim to provide a SSE for use in a solid state battery (SSB) which can resist high current densities, both at room temperature and at elevated temperatures, and thus allows for fast charging of the SSB. It is a further aim to provide a SSE which can resist a high number of lithium plating/stripping cycles, even at elevated temperatures.

It is a further aim to provide a solid state battery (SSB) comprising the inventive SSE, being capable of resisting high energy densities and high current densities, even when exposed to high temperatures such as 75 °C. It is another aim to provide a SSB which can be charged at high speed and in short time, and which can resist a high number of charging/discharging cycles, and which has thus a long lifetime.

A first aspect of the present invention relates to a solid state electrolyte (SSE) as set out in the appended claims.

The SSE comprises a dense membrane and a coating layer provided on a surface of the dense membrane. With "provided on a surface" is meant in the present disclosure "present at a surface", wherein the surface refers to the largest exposed surface.

The dense membrane comprises or substantially consists of lithium lanthanum zirconium oxide, i.e. Li₇La₃Zr₂O₁₂, abbreviated as LLZO. The LLZO can be doped LLZO. Preferably, when the LLZO is doped, the LLZO is aluminium doped LLZO, i.e. Li_{6.25}Al_{0.25}La₃Zr₂O₁₂, abbreviated as Al-LLZO.

The term "dense" is used in the present disclosure for articles having a density which is equal to or higher than 90 %, preferably at least 92 %, more preferably at least 95 %, most preferably at least 98 % of the theoretical density of the article.

For example, when the dense membrane consists of LLZO, the density of the dense membrane is at least 90 % of the theoretical density of LLZO, i.e. at least 90 % of 5.1 g/cm³ (thus at least 4.59 g/cm³).

The dense membrane has a thickness equal to or lower than 100 µm, preferably equal to or lower than 75 µm, more preferably equal to or lower than 45 µm, wherein the thickness is calculated from scanning electron microscopy (SEM) images of the SSE.

Advantageously, the dense membrane has a thickness between 2 µm and 100 µm, preferably between 3 µm and 75 µm, more preferably between 5 µm and 50 µm, such as between 10 µm and 45 µm, wherein the thickness is calculated from scanning electron microscopy (SEM) images of the SSE.

At least the surface of the dense membrane onto which the coating layer is provided is substantially free from Li₂CO₃. Advantageously, at least the surface of the dense membrane onto which the coating layer is provided is also substantially free from LiOH. Advantageously, at least the surface of the dense membrane onto which the coating layer is provided is further also substantially free from Li₂O.

With "substantially free" is meant that at least 90 % of the area of the surface, preferably at least 95 %, more preferably at least 98 %, such as at least 99 %, of the area of the surface is free from the respective compound.

The coating layer comprises or substantially consists of antimony (Sb). The coating layer has a thickness between 1 and 20 nm, preferably between 2 and 15 nm, more preferably between 5 and 10 nm, wherein the thickness is calculated from scanning electron microscopy (SEM) images of the SSE.

The SSE further comprises a first Li-Sb alloy at the interface of the coating layer comprising or substantially consisting of Sb and the dense membrane comprising or substantially consisting of LLZO.

Advantageously, the Sb-comprising coating layer is provided on a single surface of the dense membrane. Alternatively, yet also advantageously, both opposing surfaces of the dense membrane have a Sb-comprising coating layer applied thereto.

Advantageously, the SSE has a critical current density at room temperature of equal to or higher than 2 mA/cm², preferably equal to or higher than 2.5 mA/cm², more preferably equal to or higher than 3 mA/cm², such as at least 3.5 mA/cm².

A second aspect of the present invention relates to a solid state battery (SSB) as set out in the appended claims.

The SSB comprises an anode, a cathode and a SSE according to the first aspect of the invention. The anode comprises or substantially consists of metallic lithium. The anode is adjacent to the coating layer comprising or substantially consisting of Sb of the SSE.

The SSB further comprises a second Li-Sb alloy at the interface of the anode and the coating layer comprising or substantially consisting of Sb.

Advantageously, the interface resistance of the anode/SSE interface at room temperature is equal to or lower than 6 Ω.cm², preferably equal to or lower than 5.5 Ω.cm², as calculated from the impedance measurement of the SSB.

According to a third aspect of the present invention, there is disclosed a method of producing a solid state electrolyte (SSE) as set out in the appended claims. The SSE is according to the first aspect of the invention, i.e. comprises a dense membrane comprising or substantially consisting of LLZO and further comprises a coating layer comprising or substantially consisting of Sb. The dense layer and the coating layer are advantageously as described hereinabove.

The method comprises a heating operation and a deposition operation.

The heating operation comprises heating a dense membrane comprising or substantially consisting of LLZO to a temperature between 700 °C and 1000 °C, preferably between 800 °C and 900 °C. The heating is performed in an inert atmosphere, preferably an inert atmosphere comprising or substantially consisting of argon.

The heating operation removes at least partially, and preferably substantially entirely, any impurities present on the surface(s) of the dense membrane. Examples of such impurities include Li₂CO₃, LiOH and Li₂O, in particular Li₂CO₃. In other words, the heating operation advantageously results in a dense membrane having (a) substantially clean surface(s). The inventors have surprisingly discovered that the absence of Li₂CO₃ allows to obtain SSEs having a significantly increased critical current density, even when some Li₂O is present. Without wishing to be bound by any theory, the inventors believe that Li₂CO₃ has a detrimental impact on the lithium plating/stripping performance, which significantly negatively impacts both the critical current density and the number of lithium plating/stripping cycles that the SSE can withstand, while having a limited negative impact on the interface resistance.

The deposition operation comprises depositing a coating layer comprising or substantially consisting of Sb on a surface of the dense membrane, the surface being substantially free from Li₂CO₃. The coating layer has a thickness as described hereinabove, i.e. a thickness between 1 and 20 nm. A first Li-Sb alloy is formed at the interface of the dense membrane comprising or substantially consisting of LLZO and the coating layer comprising or substantially consisting of Sb during the deposition step.

The deposition of the coating layer comprising or substantially consisting of Sb can be performed by methods known in the art. Advantageously, the coating layer is deposited by means of radio frequency (RF) magnetron sputtering. Advantageously, when RF magnetron sputtering is used to deposit the coating layer, the sputtering is performed in an inert atmosphere. Advantageously, the inert atmosphere comprises or substantially consists of argon.

According to a fourth aspect of the present invention, there is disclosed a method of producing a solid state battery (SSB) as set out in the appended claims. Advantageously, the SSB is according to the second aspect of the invention, i.e. comprises an anode, a cathode and a SSE according to the first aspect or as obtained by the third aspect of the invention. Advantageously, the SSE comprises a dense membrane as described hereinabove and a coating layer comprising or substantially consisting of Sb as described hereinabove, wherein the coating layer is provided on a single surface of the dense membrane.

The method of producing a SSB comprises providing a pre-SSB, isostatically pressing the pre-SSB and heating the pre-SSB.

The pre-SSB is provided by providing an anode and a cathode at both sides of the SSE. The anode comprises or substantially consists of metallic lithium, and is provided so that the anode and the coating layer comprising or substantially consisting of Sb are adjacent.

The pre-SSB is isostatically pressed at a temperature of at least 10 MPa. It will be understood that the applied pressure is selected in function of the pressure that can be resisted by the components of the pre-SSB, in particular the dense membrane of the SSE. In particular, the pressure that can be applied increases with an increasing thickness of the dense membrane of the SSE. For example, when the dense membrane has a thickness of approx. 45 µm, a pressure between 50 and 75 MPa, preferably between 65 and 71 MPa, is applied.

Upon isostatically pressing the pre-SSB, a green SSB is obtained. The green SSB is heated to a temperature between 150 °C and 500 °C, preferably between 200 °C and 300 °C. The heating operation is performed in an inert atmosphere. Advantageously, the inert atmosphere comprises or substantially consists of argon.

A second Li-Sb alloy is formed at the interface of the anode comprising or substantially consisting of lithium metal and the coating layer comprising or substantially consisting of Sb during the heating step.

Advantages of the present invention is that the solid state battery include, without being limited thereto, a low interface resistance between its anode and the solid state electrolyte, and a very high critical current density (CCD) upon cycling, both at room temperature and at elevated temperatures up to 75 °C. Without wishing to be bound by any theory, the inventors believe that the presence of a first and a second Li-Sb alloy contribute in obtaining a homogeneous interface, thereby reducing the interface resistance and increasing the CCD.

Consequently, such an improved anode/SSE interface also has the advantage of improving the number of charging/discharging that the battery can undergo before failing, thereby increasing the lifetime of the battery, and this even at high current densities (because of the high CCD).

### Description of the figures

Aspects of the invention will now be described in more detail with reference to the appended drawings, wherein same reference numerals illustrate same features and wherein:
- Figure 1 schematically shows a first solid state electrolyte (SSE) of the invention;
- Figure 2 schematically shows a second SSE of the invention;
- Figure 3 schematically shows a first solid state battery (SSB) of the invention, comprising the first SSE of Figure 1;
- Figure 4 schematically shows a second SSB of the invention, comprising the second SSE of Figure 2;
- Figures 5A and 5B show SEM images of the surface and the cross-section, respectively, of an first LLZO-comprising dense membrane;
- Figure 6 shows the SEM image of the cross-section of a second LLZO-comprising dense membrane;
- Figure 7 shows the composition of a dense membrane as measured by means of X-ray photoelectron spectroscopy (XPS), represented by the atomic concentration of O 1s in function of the sputtering time/depth of the XPS analysis;
- Figures 8 and 9 show the impedance measurement of a lithium symmetrical cell with a reference SSE and with a first inventive SSE at room temperature and at 75 °C, respectively;
- Figure 10 shows the cell potential and the current density in function of the time for a lithium symmetrical cell with a first inventive SSE at room temperature;
- Figure 11 shows the cell potential and the current density in function of the capacity for a lithium symmetrical cell with a first inventive SSE at 75 °C;
- Figure 12 shows the cell potential and the current density in function of the time for a lithium symmetrical cell with a second inventive SSE at 75 °C;
- Figure 13 shows the cell potential in function of the time and the number of charging/discharging cycles for a lithium symmetrical cell with a first inventive SSE at 75 °C;
- Figure 14A and 14B show the cell potential in function of the time up to 25 hours upon galvanostatic cycling for a reference symmetrical cell and a lithium symmetrical cell with a first inventive SSE, respectively, at 75 °C;
- Figures 15A and 15B show SEM images of the cross-section of a reference symmetrical cell and a lithium symmetrical cell with a first inventive SSE, respectively after 25 hours and 900 hours of galvanostatic cycling, respectively.

### Detailed description of the invention

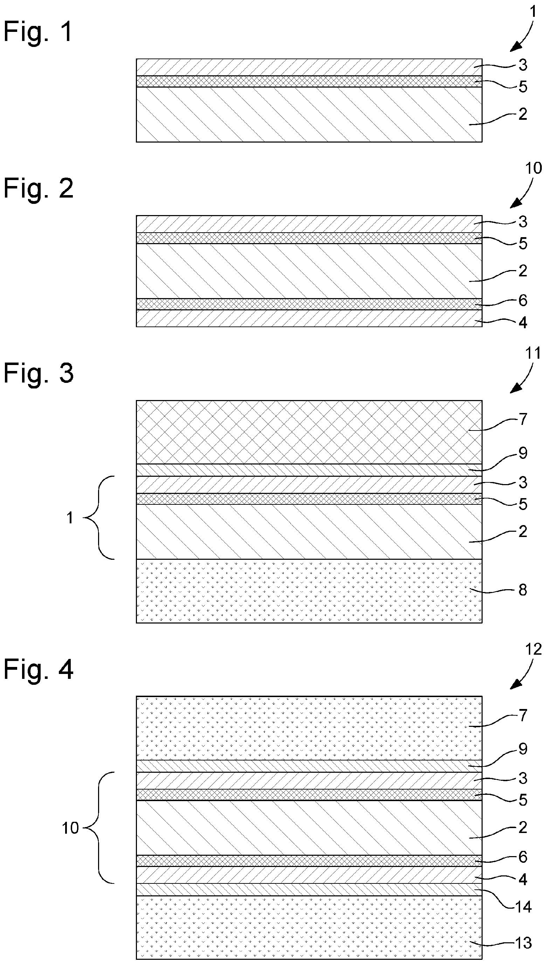

Fig. 1 shows a schematical representation of a solid state electrolyte 1 according to the present disclosure. The SSE 1 comprises a dense membrane 2 comprising or substantially consisting of LLZO and a coating layer 3 comprising or substantially consisting of Sb. Advantageously, the coating layer consists of Sb.

Advantageously, the dense membrane 2 has a thickness between 5 and 50 µm, such as between 15 µm and 45 µm. Such dense membranes can be produced by methods known in the art. A particular method comprises preparing a slurry comprising LLZO, optionally doped, tape-casting the slurry, de-binding (annealing) the slurry and sintering the green membrane to densify it. Sintering advantageously comprises or substantially consists of ultra-fast sintering (UFS). Advantageously, the (ultra-fast) sintering is performed in an inert atmosphere, thereby limiting the formation of carbon-comprising contaminants, such as Li₂CO₃, at the surface of the membrane.

The surface of the dense membrane forming an interface with the coating layer 3 comprising or substantially consisting of Sb is advantageously free from Li₂CO₃. Advantageously, and additionally, the surface is also free from LiOH and/or Li₂O.

Advantageously, the dense membrane has a surface roughness of a few nanometers. In other words, when the thickness of the dense membrane is for example 45 µm, the thickness is, depending on the position along its surface where the thickness is measured, comprised between 44.998 µm and 45.002 µm.

Advantageously, the Sb-comprising coating layer 3 has a thickness between 1 and 20 nm, preferably between 5 and 10 nm.

The SSE 1 further comprises a first Li-Sb alloy 5 at the interface of the dense membrane 2, in particular the lithium comprised within the dense membrane 2, and the Sb-comprising coating layer 3.

Advantageously, the first Li-Sb alloy 5 comprises or substantially consists of Li₂Sb. The Li-Sb alloy may further comprise LisSb, although the inventors believe that the deposition of the coating layer 3 on the dense membrane 2 is rate-limited by the dissolution and solid-state diffusion of Li from the LLZO comprised in the dense membrane 2 into the Sb-comprising coating layer 3, thereby primarily forming Li₂Sb.

Advantageously, the SSE 1 has a critical current density (CCD) at room temperature of equal to or higher than 2 mA/cm², preferably equal to or higher than 3 mA/cm.

Advantageously, the SSE 1 has a CCD at 75 °C of equal to or higher than 30 mA/cm², preferably equal to or higher than 50 mA/cm², more preferably at least 60 mA/cm², such as 70 mA/cm².

The SSE 1 schematically shown in Fig. 1 is particularly suited for use in a solid state battery (SSB) comprising an anode comprising or substantially consisting of metallic lithium.

Fig. 2 schematically shows a further SSE 10 of the invention, comprising the dense membrane 2 as described hereinabove. A coating layer 3, 4 comprising or substantially consisting of Sb is provided on both surfaces of the dense membrane 2, with a first Li-Sb alloy 5, 6 present at the interface of each coating layer 3, 4 and the dense membrane 2. The coating layer 3, 4 and the first Li-Sb alloy 5, 6 are as described hereinabove for Fig. 1.

The SSE 10 schematically shown in Fig. 2 is particularly suited for use in a symmetrical cell for performance analysis of the SSE, for example a symmetrical cell comprising two electrodes comprising or substantially consisting of metallic lithium.

Fig. 3 shows a schematical representation of a solid state battery 11 of the invention. The SSB 11 comprises the SSE 1 of Fig. 1. An anode 7 comprising or substantially consisting of metallic lithium is present adjacent to the Sb-coating layer 3. A second Li-Sb alloy 9 is present at the interface of the anode 7, in particular the metallic lithium comprised therein, and the Sb-coating layer 3.

The anode 7 can be any metallic lithium comprising anode known in the art. Advantageously, the anode consist of metallic lithium.

Advantageously, the second Li-Sb alloy 9 comprises or substantially consists of Li₂Sb. The Li-Sb alloy may further comprise Li₃Sb.

The SSB 11 further comprises a cathode 8 provided adjacent to the surface of the dense membrane 2 opposite to the surface adjacent to the Sb-coating layer 3. The cathode can be any cathode known in the art, in particular any cathode known in the art for Lithium-ion (secondary) batteries.

Fig. 4 schematically shows a symmetrical cell for testing purposes, for example a lithium symmetrical cell. The symmetrical cell 12 comprises the SSE 10 of Fig. 2 and two electrodes 7, 13 comprising or substantially consisting of metallic lithium provided adjacent to the coating layers 3, 4. A second Li-Sb alloy 14 is present at the interface of the second electrode 13, in particular the metallic lithium comprised therein, and the adjacent Sb-coating layer 4.

Although an increase in the critical current density (CCD) could be expected when compared to thicker LLZO-based SSEs, such as LLZO pellets having a thickness of 1 mm, the inventors have surprisingly noticed that the increase realised with the LLZO-comprising SSEs of the present disclosure significantly exceeds the expectations. Where, based on what is known in the art, a 2-fold increase could be expected, the inventors have realised at least a 4-fold increase, and even a 5.5-fold increase.

Without wishing to be bound by any theory, the inventors believe that this improved performance (increased CCD) is realised by the use of LLZO-comprising dense membranes, which are further substantially free from Li₂CO₃ at their surface forming an interface with the Sb-comprising coating, as well as an improved deposition of the antimony-comprising layer on the surface of the LLZO-comprising dense membrane, thereby obtaining a more uniform interface and a more optimal Li-Sb alloy at the interface.

### Examples

To test the performance of the solid state electrolytes (SSE) of the invention, lithium symmetrical cells are prepared with two inventive LLZO-comprising SSEs. A lithium symmetrical cell with a reference LLZO SSE was prepared as well. The reference LLZO SSE consisted of a 45 µm thick dense LLZO membrane. The inventive SSEs comprised a 15 µm or 45 µm thick dense LLZO membrane and a 10 nm antimony (Sb) coating on both surfaces.

The dense thick LLZO membranes were manufactured by mixing 4.3 mL solvent comprising 5 vol.% isopropanol, 87 vol.% ethanol and 8 vol.% 1-propanol, 0.408 mL plasticizer and 0.43 g surfactant. For 45 µm thick dense LLZO membranes, 3 g of Al-doped LLZO powder was then added to the mixture, while for the 15 µm dense LLZO membrane a mixture of 3 g of Al-doped LLZO and 7 % by weight of Li₂CO₃ was added.

The LLZO-comprising mixtures were then ball milled at 165 rpm for 18 hours to obtain a suspension. Afterwards, 2 mL binder solution (polyvinyl butyral and isopropanol in a weight ratio of 30 to 70) was added to the suspension, followed by further ball milling at 200 rpm for 2 hours, until a homogeneous slurry was obtained. The homogeneous slurry was then tape casted on a glass plate at speed of 1 mm/s, using a doctor-blade with a 400 µm opening for 45 µm dense LLZO membranes and an opening of 150 µm for 15 µm dense LLZO membranes.

The tape casted layers were then air dried for 30 minutes, and peeled off from the glass substrate and laser cut into discs of 10 mm diameter.

The LLZO membrane discs were placed between flat and microporous alumina plates and de-binded (annealed) under a flow of oxygen in a muffle furnace at 150 °C for 2 hours, then 400 °C for 2 hours and 600 °C for 2 hours, at a heating rate of 300 °C/hour, followed by natural cooling.

After annealing, the LLZO membranes were sintered to obtain dense membranes. The sintering was performed by ultra-fast sintering (UFS) in an argon filled glovebox, and the membranes were placed in a graphite envelope, which was sandwiched between two boron nitride plates. The entire stack was placed in the slit of the carbon felt of the UFS apparatus. The sintering was performed at 1200 °C for 50 seconds for the 45 µm membranes and at 1150 °C for 50 seconds for the 15 µm membrane.

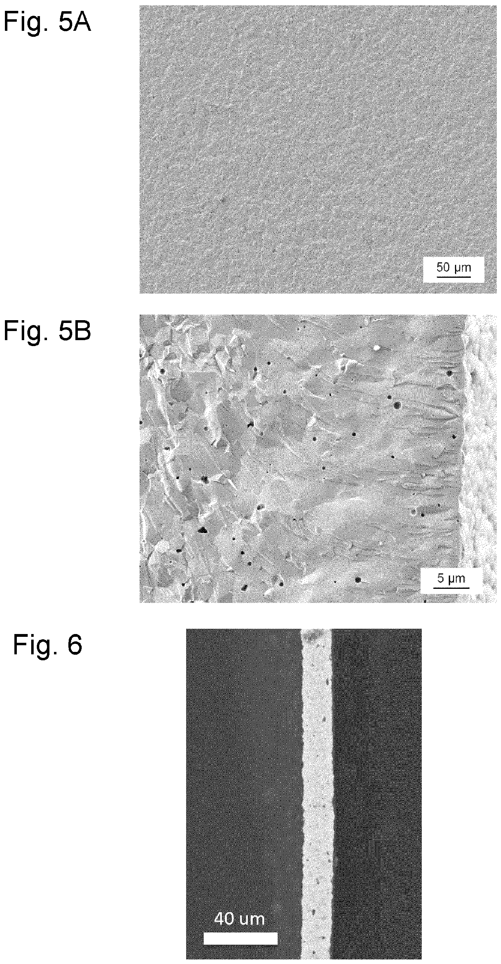

Fig. 5A and Fig. 5B show scanning electron microscopy (SEM) images of the surface and the cross-section of the 45 µm LLZO membrane. From Fig. 5A it is clear that the surface is pinhole-free, while from Fig. 5B it is clear that a very homogeneous and highly dense (i.e. having a low porosity) LLZO membrane was obtained.

Fig. 6 shows the SEM image of the cross-section of the 15 µm LLZO membrane. It is again clear that the membrane is very homogeneous and has a high density (i.e. a low porosity).

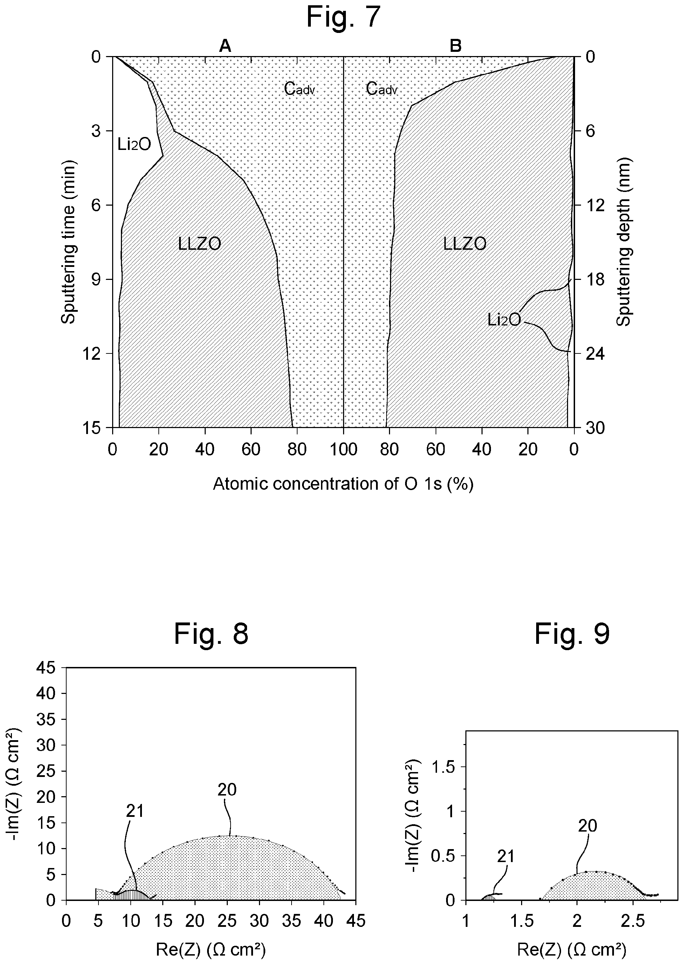

One 15 µm LLZO membrane and two 45 µm LLZO membranes were then heated at 900 °C for 10 minutes in an argon filled glovebox to remove any impurities. Fig. 7 shows the composition of the dense membrane as measured by means of X-ray photoelectron spectroscopy (XPS), which is represented by the atomic concentration of O 1s in function of the sputtering time/depth of the XPS analysis, for the dense membrane after UFS and prior to heating (A), and after UFS and heating (B). Prior to heating some Li₂O is found at low sputtering depths, i.e. at the surface, and substantially no Li₂CO₃. After heating, the amount of Li₂O as impurity has decreased along the entire depth (thickness) of the membrane, and it is found only in minute amounts at higher depths within the dense membrane. Without wishing to be bound by any theory, the inventors believe that the Li₂O is re-integrated inside the LLZO structure during the heat treatment.

A reference lithium symmetrical cell was prepared by providing 3 mm diameter lithium disks at each side of a 45 µm LLZO membrane, followed by vacuum sealing the Li/LLZO/Li stack in a latex container and isostatically pressing the stack at 71 MPa for a few minutes.

Two lithium symmetrical cells with an inventive SSE were prepared by sputtering a 10 nm Sb coating layer (3 mm diameter) on both sides of the 15 µm LLZO membrane and on both sides of a 45 µm LLZO membrane by means of radio frequency magnetron sputtering using a Sb target (purchased from Plasmaterials) under an argon flow of 50 sccm (sputtering equipment: Orion, AJA International Inc.). The Sb coating layer thickness was tuned by measuring the deposition rate with a quartz crystal microbalance (QCM) and adjusting the deposition time accordingly.

Then, 3 mm diameter lithium disks were provided at each side of the Sb-LLZO membranes, followed by vacuum sealing the Li/Sb-LLZO/Li stack in a latex container and isostatically pressing the stack for a few minutes. For the 45 µm LLZO membrane, a pressure of 71 MPa was applied. For the 15 µm LLZO membrane, a pressure of 10 MPa was applied.

All three lithium symmetrical cells were then heated to 250 °C on a hot plate in an argon filled glovebox for 1 hour.

The interface resistance was measured by impedance measurement using a Biologic MTZ-35 analyser. Fig. 8 shows the results of the impedance measurement for the reference symmetrical cell 20 and the inventive symmetrical cell 21 comprising a 45 µm LLZO membrane at room temperature and Fig. 9 shows the results at 75 °C. From these impedance measurements, the interface resistance can be calculated by multiplying the measured interfacial impedance by the area of the sample. A smaller surface below the impedance curve indicates a lower interface resistance. It is clear that for both temperatures tested, the inventive cell has a significantly lower interface resistance than the reference cell: 5.35 Ω.cm² vs. 34.8 Ω.cm² at room temperature and 0.129 Ω.cm² vs. 0.948 Ω.cm² at 75 °C. A lower interface resistance is a measure for a higher performing battery.

The critical current density (CCD) was also measured at room temperature and at 75 °C. The CCD is the highest current density that a SSE can sustain before breakdown, and is the current density that a battery cell can endure through cycling without cell failure. The CCD was measured by repeated charging and discharging of the symmetrical cells at a capacity limit of 0.1 mAh/cm² and by increasing the current step in a stepwise manner from 0.1 mA/cm² to a maximal value of 100 mA/cm² until a short circuit is noticed.

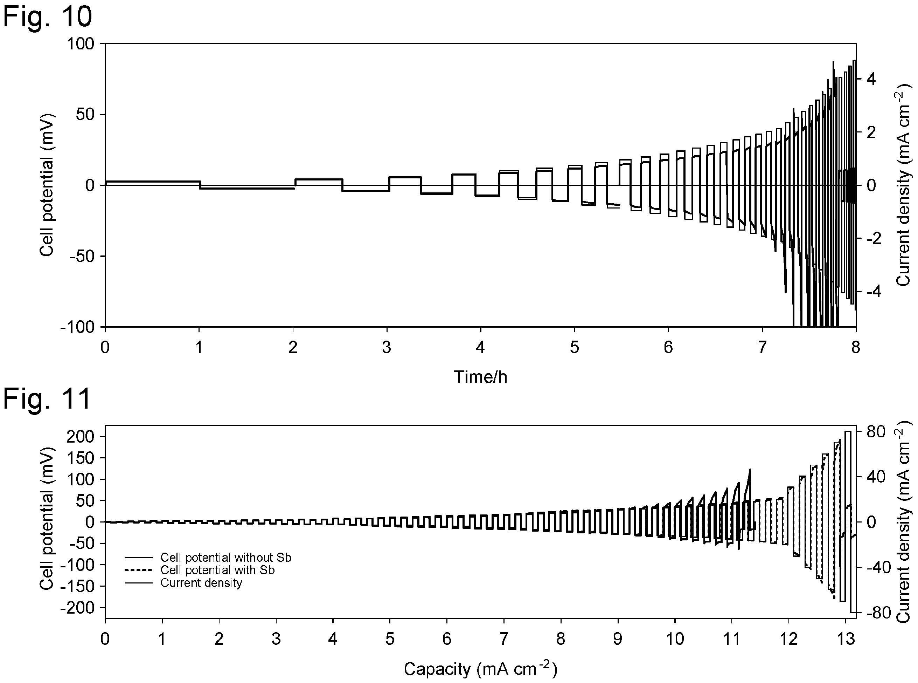

Fig. 10 shows the cell potential and the current density for the symmetrical cell with the inventive SSE comprising the 45 µm LLZO membrane at room temperature. The current density at failure, which was shortly before 8 hours of charging and discharging, was 3.62 mA.cm⁻². Fig. 11 shows the cell potential and the current density in function of the capacity at 75 °C, for the symmetrical cell with the inventive SSE comprising the 45 µm LLZO membrane and the reference cell. It is clear that the cell with the inventive SSE shows failure at a higher capacity, and that the current density at failure (the CCD) is significantly larger: 70 mA.cm⁻² vs. 16 mA.cm⁻² for the reference cell.

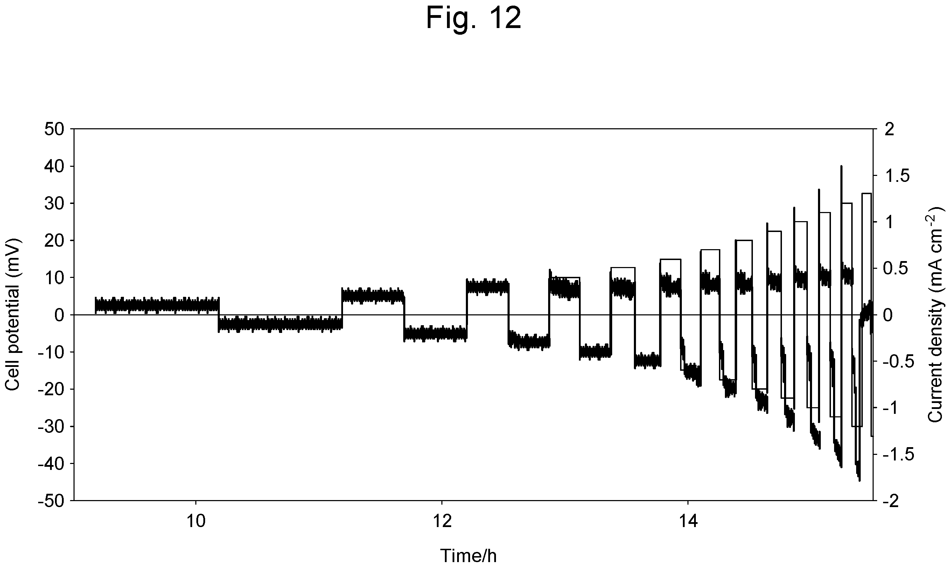

Fig. 12 shows the cell potential and the current density for the symmetrical cell with the inventive SSE comprising the 15 µm LLZO membrane at 75 °C, which indicate a CCD of 1.2 mA.cm⁻².

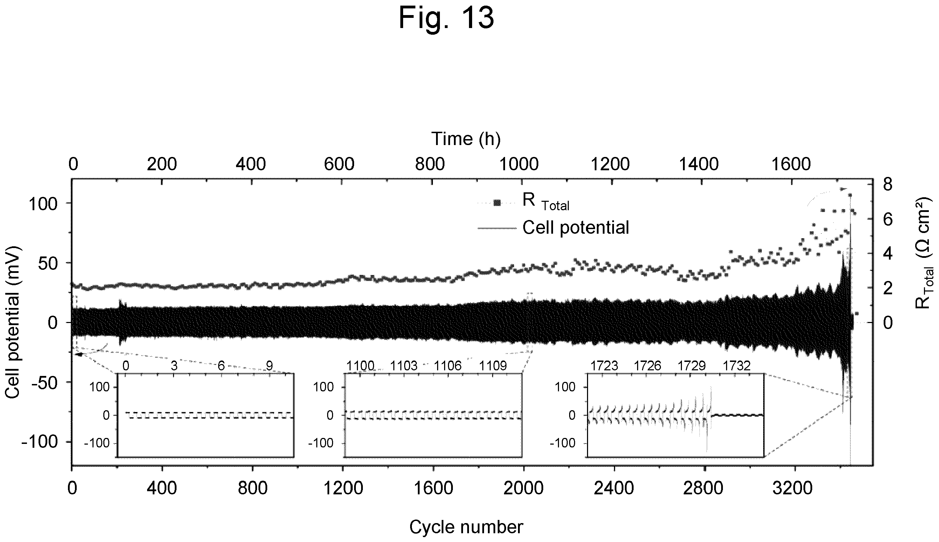

The cycling behaviour was also tested for the lithium symmetrical cell comprising the inventive SSE with the 45 µm LLZO membrane. Galvanostatic cycling was performed at a temperature of 75 °C and at a (high) current rate of 4 mA.cm⁻² and a capacity limit of mAh.cm⁻². Fig. 13 shows the results up to almost 3500 cycles, or almost 1800 hours, from which it is clear that a very stable behaviour is maintained up to approx. 1730 cycles.

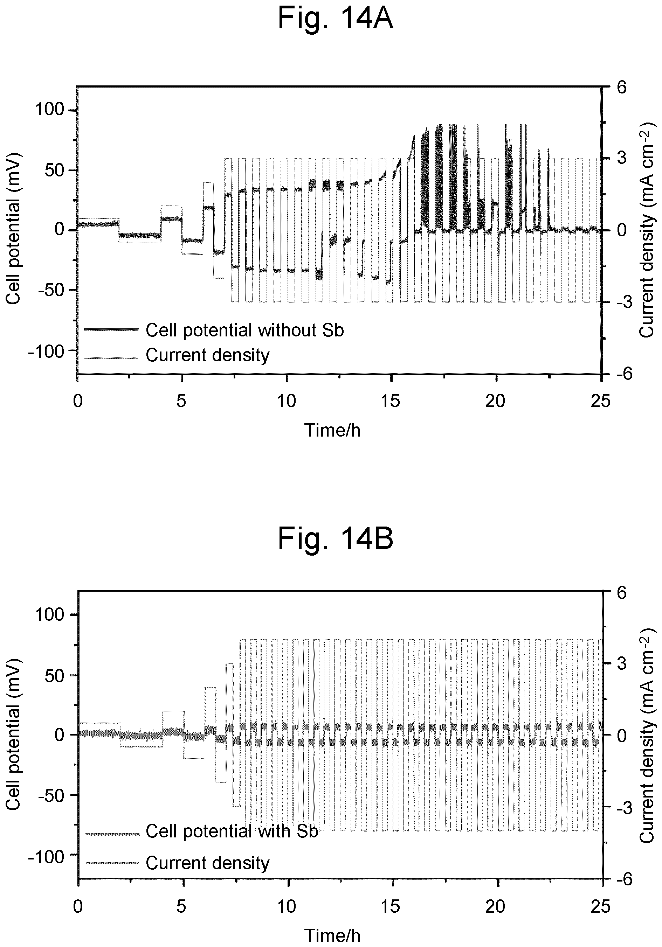

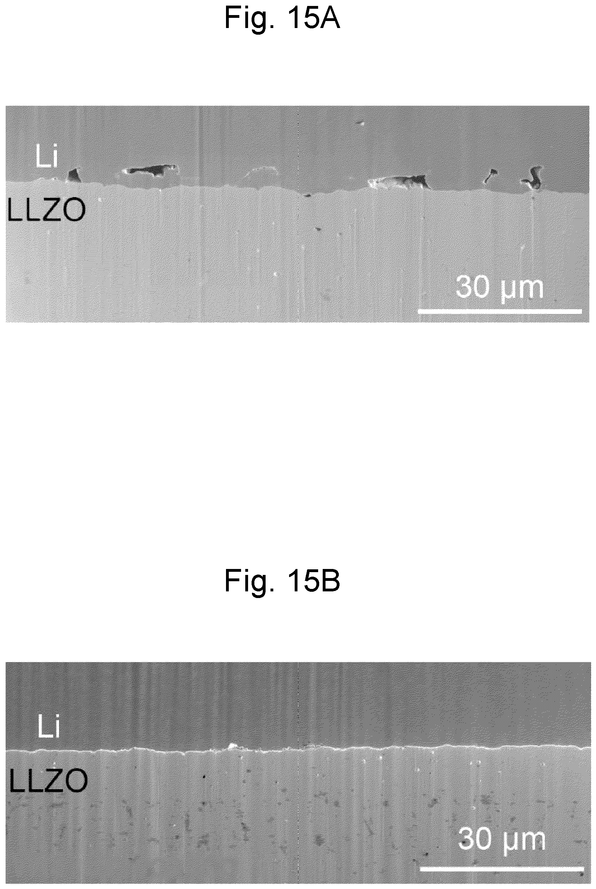

The reference lithium symmetrical cell was also galvanostatic cycled under the same conditions. Fig. 14A and Fig. 14B show the results up to 25 hours cycling for the reference cell and the lithium symmetrical cell comprising the inventive SSE with the 45 µm LLZO membrane, respectively. It is clear that the reference cell fails already after 15 hours of testing. To evaluate the difference in cycle duration until failure (15 hours vs. almost 1800 hours), SEM images of the cross-section of the failed reference cell (after 25 hours) - Fig. 15A - and of the lithium symmetrical cell comprising the inventive SSE with the 45 µm LLZO membrane after 900 hours cycling - Fig. 15B - were compared. It is clear that for the reference cell voids were created after already 25 hours of cycling, whereas for the inventive SSE, no voids were reacted after 900 hours of cycling.

It is believed by the inventors that the Li-Sb alloy present at both the metallic Li/Sb-coating interface and at the Sb-coating/LLZO interface allow for a better electronic percolation and an effective and homogeneous transfer of Li ions between the metallic lithium and the LLZO, which mitigates the formation of voids at the metallic lithium/SSE interface.

### Nomenclature

- 1.: solid state electrolyte
- 2.: dense membrane
- 3.: Sb-comprising coating layer
- 4.: Sb-comprising coating layer
- 5.: first Li-Sb alloy
- 6.: first Li-Sb alloy
- 7.: metallic lithium comprising anode
- 8.: cathode
- 9.: second Li-Sb alloy
- 10.: solid state electrolyte
- 11.: solid state battery
- 12.: solid state battery
- 13.: metallic lithium comprising cathode
- 14.: second Li-Sb alloy
- 20.: impedance measurement for a reference symmetrical cell
- 21.: impedance measurement for an inventive symmetrical cell

## Claims

1. A solid state electrolyte (SSE) (1, 10) comprising a dense membrane (2) comprising lithium lanthanum zirconium oxide (LLZO) and a coating layer (3, 4) comprising antimony (Sb) provided on a surface of the dense membrane (2), wherein the dense membrane (2) has a density equal to or higher than 90 % of the theoretical density of the membrane, wherein the Sb-comprising coating layer (3, 4) has a thickness between 1 and 20 nm, **characterised in that** the dense membrane (2) has a thickness equal to or lower than 100 µm, **in that** at least the surface of dense membrane (2) onto which the coating layer is provided is substantially free from Li₂CO₃, and **in that** the SSE (1, 10) comprises a first Li-Sb alloy (5, 6) at the interface of the Sb-comprising coating layer (3, 4) and the LLZO-comprising dense membrane (2), wherein the thicknesses are as calculated from scanning electron microscopy (SEM) images of the SSE (1, 10).

2. The SSE (1, 10) according to claim 1, wherein the dense membrane (2) has a thickness between 5 and 50 µm.

3. The SSE (1, 10) according to any one of the preceding claims, wherein the Sb-comprising coating layer (3, 4) has a thickness between 5 and 10 nm.

4. The SSE (1, 10) according to any one of the preceding claims, wherein the Sb-comprising coating layer (3) is provided on a single surface of the dense membrane (2).

5. The SSE (1, 10) according to any one of the preceding claims, wherein the LLZO is doped LLZO, preferably aluminium doped LLZO.

6. The SSE (1, 10) according to any one of the preceding claims, having a critical current density at room temperature of equal to or higher than 2 mA/cm², preferably equal to or higher than 3 mA/cm².

7. A solid state battery (SSB) (11, 12) comprising a SSE (1, 10) of any one of the preceding claims, an anode (7) comprising metallic lithium and a cathode (8, 13), wherein the anode (7) is adjacent to the coating layer (3) comprising Sb, and wherein the SSB (11, 12) comprises a second Li-Sb alloy (9) at the interface of the anode (7) and the Sb-comprising coating layer (3) of the SSE (1, 10).

8. The SSB (11, 12) according claim 7, wherein the interface resistance of the anode-SSE interface at room temperature is equal to or lower than 6 Ω.cm², as calculated from the impedance measurement of the SSB.

9. A method of producing a solid state electrolyte (SSE) (1, 10) comprising a dense membrane (2) comprising LLZO and a coating layer (3, 4) comprising Sb, comprising the steps of:
- Heating a dense membrane (2) comprising LLZO to a temperature between 700 °C and 1000 °C in an inert atmosphere, wherein the dense membrane (2) has a density equal to or higher than 90 % of the theoretical density of the membrane, and wherein the dense membrane (2) has a thickness equal to or lower than 100 µm, as calculated from SEM images of the dense membrane (2), thereby obtaining a dense membrane (2) having a surface which is substantially free from Li₂CO₃,
- Depositing a coating layer (3, 4) comprising Sb on the surface of the dense membrane (2) which is substantially free from Li₂CO₃, thereby obtaining the SSE (1, 10), wherein the Sb-comprising coating layer (3, 4) has a thickness between 1 and 20 nm, as calculated from SEM images of the SSE (1, 10),
**characterized in that** depositing the Sb-comprising coating layer (3, 4) forms a first Li-Sb alloy (5, 6) at the interface of the Sb-comprising coating layer (3, 4) and the LLZO-comprising dense membrane (2).

10. The method according to claim 9, wherein the Sb-comprising coating layer (3, 4) is deposited by means of radio frequency (RF) magnetron sputtering.

11. The method according to claim 10, wherein the RF magnetron sputtering is performed in an inert atmosphere.

12. The method according to any one of claims 9 to 11, wherein the dense membrane (2) is heated at a temperature between 800 °C and 900 °C.

13. The method according to any one of claims 9 to 12, wherein the LLZO is doped LLZO, preferably aluminium doped LLZO.

14. A method of producing a solid state battery (SSB) (11, 12) comprising a SSE (1) of any one of claims 1 to 6 or a SSE (1) obtained by the method of any one of claims 9 to 13, wherein the Sb-comprising coating layer is provided on a single surface of the dense membrane (2), the method comprising the steps of:
- Providing an anode comprising metallic lithium and a cathode at both sides of the SSE, wherein the anode is adjacent to the Sb-comprising coating layer of the SSE, thereby obtaining a pre-SSB,
- Isostatically pressing the pre-SSB at a pressure of at least 10 MPa, thereby obtaining a green SSB,
- Heating the green SSB to a temperature between 150 °C and 500 °C in an inert atmosphere, thereby forming a second Li-Sb alloy at the interface of the anode and the Sb-comprising coating layer of the SSE, and obtaining the SSB.

15. The method according to claim 14, wherein the green SSB is heated to a temperature between 200 °C and 300 °C.
